# EUROPEAN PATENT APPLICATION

(11) **EP 2 168 917 A1**
(43) Date of publication of application: **31.03.2010**
(21) Application number: 08775441.2
(22) Date of filing: 28.05.2008
(51) Int. Cl.: C01B 33/027, C30B 31/06, H01L 21/205, C30B 25/00

(54) **MICROSPHERES OF SILICON AND PHOTONIC SPONGES, METHOD FOR PRODUCTION AND USES THEREOF IN THE MANUFACTURE OF PHOTONIC DEVICES**

(30) Priority: 18.06.2007 ES 200701681
(71) Applicant: Consejo Superior De Investigaciones Científicas, 28006 Madrid (ES)
(72) Inventor: MESEGUER RICO, Francisco Javier, E-28049 Madrid (ES); FENOLLOSA ESTEVE, Roberto, E-28049 Madrid (ES); TYMCZENKO, Mikael, E-28049 Madrid (ES)
(74) Representative: Pons Ariño, Angel
(86) International application number: PCT/ES2008/070102
(87) International publication number: WO 2008/155438

(57) **Abstract**

The invention concerns a microsphere of silicon with a diameter between 0.1 and 50 micras capable of functioning as an optical microcavity with Mie resonant modes for wavelengths in the range between 1 and 15 micras, and a photonic sponge formed from the former. Preparation thereof is achieved by means of a simple method based on the decomposition by heating of the gaseous precursors. The use of these microspheres and photonic sponges are useful for manufacturing photonic devices, for example, solar cells, photo diodes, lasers and sensors.

## Description

### FIELD OF THE INVENTION

This invention relates in general to the field of manufacturing microstructured materials. In particular it relates also to the field of optical microcavities and photonic devices, and to the field of photovoltaic cells, lasers and sensors.

### STATE OF THE TECHNIQUE

The confinement of electromagnetic energy in small cavities is a phenomenon with enormous potential. In particular, the phenomenon of light resonance in cavities with a size comparable to the wavelength, in the visible and near-infrared range, is being studied by researchers and microelectronics companies throughout the world. The fact of confining the electromagnetic field into cavities of this type, referred to as microcavities, has given rise to interesting technological applications. In the first place, the microcavities are key elements in the manufacture of micrometric-sized photonic devices, for example, multiplexors and de-multiplexors [S. Noda, A. Chutinan, M. Imada, Nature 407, 608, 2000]. At the same time, microcavities also notably favour non-linear optical interactions like for example the Raman interaction. This can be used in order to detect a liquid or gas that is close to the microcavity. Another type of application is micrometer-sized devices that emit or detect light, such as for example microlasers, which have been manufactured by placing an active material inside a microcavity [O. Painter, R.K. Lee, A. Scherer, A. Yariv, J.D. O'Brien, P.D. Dapkus, I. Kim, Science 284, 1819, 1999].

The development of microcavities that allow resonance modes with a high quality factor (Q), defined as the ratio between the amount of energy stored and that dissipated per cycle, in which the confinement volume of the field (V) is very small, has made it possible to carry out experiments of quantum electrodynamics through the use of materials with well defined electronic levels like quantum points and even monoatomic gases. In this way it has been possible to observe the Purcell effect and Rabi splitting [K. Hennessy, A. Badolato, M. Winger, D. Gerace, M. Atatüre, S. Gulde, S. Fält, E.L. Hu, A. Imamoglu, Nature 445, 896, 2007].

The different types of microcavities that have been manufactured to date can be summarised as follows: micropillars, microdisks, photonic crystal cavities, microspheres and microtoroids [K.J. Vahala 424, 839, 2003]. In all of them, the physics are determined by the Q/V ratio. High Q values and low V values are necessary for the abovementioned phenomena to occur. The quality factor depends on various aspects: the refractive index of the microcavity, the resonance mechanism, etc. Whispering gallery mode resonators provide the highest quality factors achieved to date. The record value of 8×E9 for Q was achieved in silicon oxide microspheres [M.L. Gorodetsky, A.A. Savchenkov, V.S. Ilchenko, Opt. Lett. 21, 453, 1996]. However, their diameter and therefore the volume, V, was relatively large, in the region of several dozen micras. The reason for this is due to the low contrast of the refractive indices between the sphere and the atmosphere, n_sphere/n_air=1.45, and to the underlying resonance mechanism which is the total internal reflection of the light inside the sphere. One strategy to reduce the size of the sphere while maintaining a high Q value consists of increasing its refractive index. This would happen, for example, if the sphere were made of silicon. In this case, the contrast between the refractive indices would be: n_sphere/n_air=3.5 in near-infrared.

One would mention various methods that have been used to date to manufacture silicon spheres. For example, the methods described in patents US No 5.069.740 and US No 4.637.855. However, these are apparently spheres of a much greater size than those introduced in this patent. They have diameters of 0.5 mm or more. These inventions were made with a view to their application in the field of photovoltaic cells, since millimetre-sized silicon spheres capture light better than planar structures due to geometrical effects.

### DESCRIPTION OF THE INVENTION

### Brief Description

One aspect of the invention consists of a microsphere, hereinafter microsphere of the invention, of silicon, with a diameter between 0.1 and 50 micras, preferably between 0.5 and 5 micras, with controlled porosity and capable of functioning as an optical microcavity with Mie resonance modes for wavelengths in the range between 1 and 15 micras, in which the silicon is transparent.

Another aspect of the invention consists of a photonic sponge, hereinafter photonic sponge of the invention, formed by conglomerations or by random distributions of many units of the microspheres of the invention, whether of one single material or different materials, in a stack, of the coating or layer type, over plane, curved or any type of surfaces. These sponges can localise light in very small spaces, in a range of wavelengths in which the silicon is transparent, specifically between 1 and 15 micras.

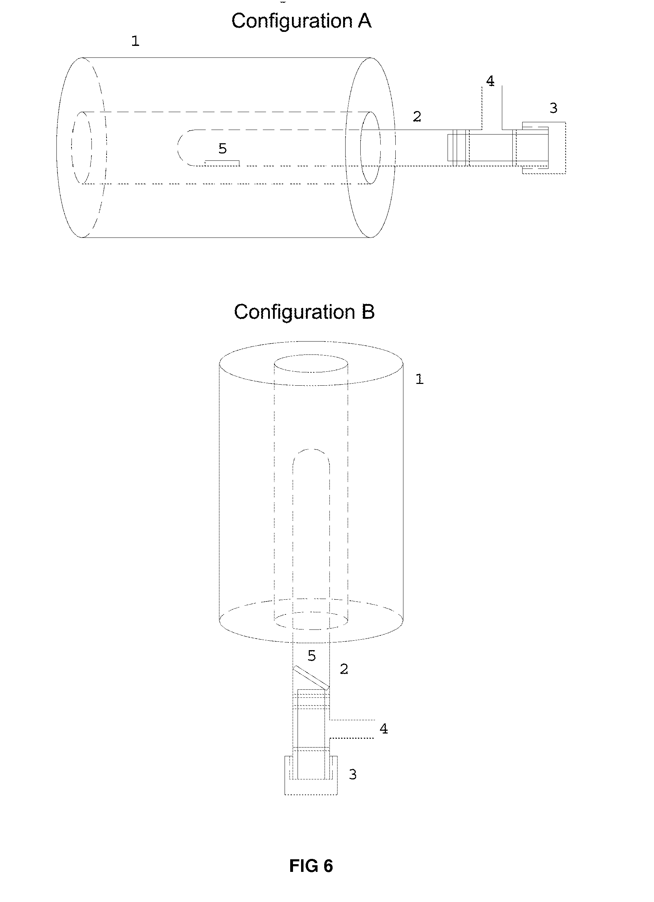

Another aspect of the invention consists of the method for producing the microspheres of the invention, hereinafter method of the invention, which comprises the following stages (see Figure 6):
a) Stage of selection and arrangement of the material, volume and shape of the reaction vial or container (2), as well as of the material, shape and location of the substrate (5) inside it for assembly for the chemical vapour deposition,
b) Stage of decomposition by heating of the precursor compound(s) of silicon, preferably silane and/or disilane, in the form of a gas that is placed inside the reactor/vial, where it is subjected to the right pressure, temperature and time conditions for decomposition,
c) Stage of synthesis of the microsphere of the invention based on the chemical vapour deposition that diffuses in the gas, forming nuclei of the material, preferably silicon, in the midst of the gas,
d) Precipitation or depositing of the microspheres in the form of rain and their depositing on the substrate inside the container or on the container walls (see examples),
e) Formation of the photonic sponges,
f) Extraction of the surplus gases from the container or vial (2) using an assembly for chemical vapour deposition,
g) Opening the container or vial (b) and extracting the substrate (d) and the microspheres and photonic sponges stuck to the container and to the substrate for their subsequent purification.

Finally, another aspect of the invention consists of the use of the microspheres and photonic sponges of the invention in the manufacture of photonic devices, for example, solar cells, photodiodes, lasers and sensors.

### Detailed Description

The microspheres and the photonic sponge described in this invention represent a new concept for capturing light that can be applied to different devices such as photovoltaic cells, photodiodes, lasers, and chemical and biological sensors, among others. In fact, this new concept is based on the conjunction of two phenomena, on the one hand the light resonance within the microspheres. What is the other phenomenon? The sentence is inconclusive. As a consequence of said resonance the luminous energy concentrates enormously inside and, secondly, said concentration produces non linear optical phenomena that are favoured by the resonances such as the absorption of two or more photons at the same time. The application to solar cells and photodiodes is very similar since it is based on the detection of photons in a homojunction p-n or a p-i-n type heterojunction. This makes it possible to extend the absorption range to the entire solar spectrum. The resonance itself can be used in other applications such as lasers. Thus, if fluorescent substances are introduced or adsorbed in their surface these microcavities will act as very small resonant cavities that excite the luminescence of the fluorochromes and can produce population inversion and therefore a laser effect.

The application to sensors is based on the following fact: the resonances in the microcavities appear at different frequencies (or wavelengths). This effect gives rise to minimums in the optical transmittance. Because the silicon spheres may present porosity according to their processing parameters, they can act as sensors. If in the pores of the sphere a chemical or biological product is introduced, this will modify the refractive index of the microcavity. Therefore, the resonances change position in wavelength and therefore, the substance is detected.

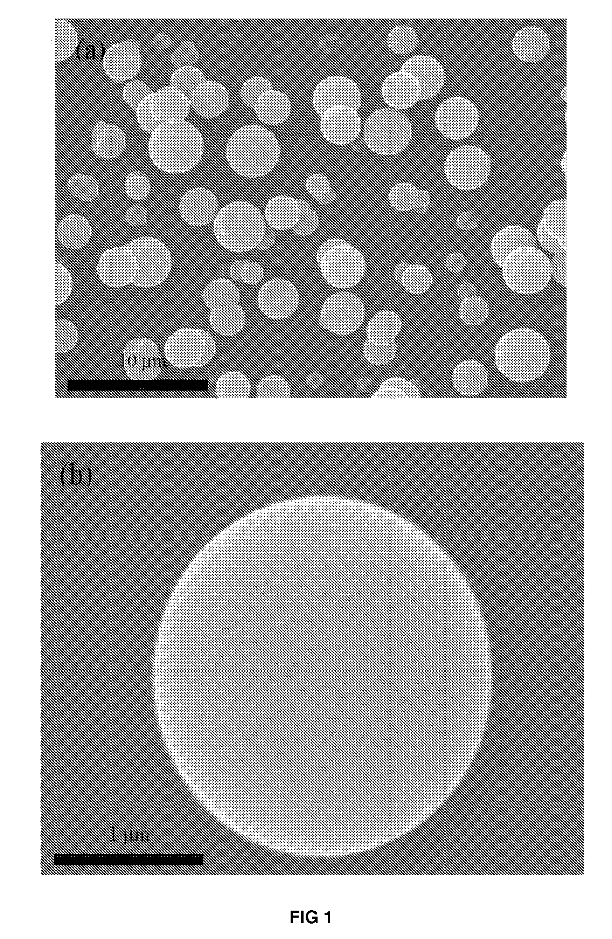

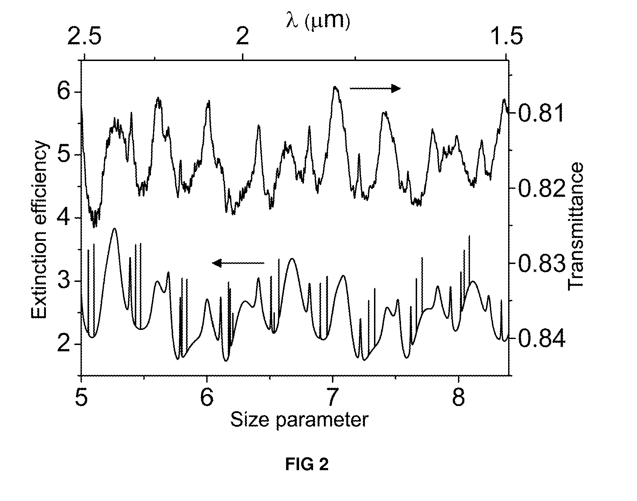

In the first place a silicon sphere is described with a diameter between 0.1 and 50 micras and the method for obtaining it. More specifically, these microspheres present a dispersion of sizes as shown in Figure 1 (a) as well as controlled porosity, high sphericity and a very smooth surface as shown in Figure 1 (b). This enables them to function as optical microcavities with Mie resonance modes or whispering gallery modes. Given their size (of up to 50 micras in diameter and bearing in mind the spectral region in which silicon is transparent, these resonances appear in a spectral range between 1 and 15 micras, in which the silicon is transparent. Figure 2 shows measurements of the optical transmittance of just one sphere of 1.88 micras in diameter (in red). Figure 2 also shows the theoretical calculations of optical transmittance (in black) according to the Mie theory for a sphere of that size and supposing that it is made of polycrystalline silicon. The coincidence between these peaks and those of the transmittance spectrum can be clearly observed. Figure 2 also shows the assignment of the different resonances to the different modes of the microcavity amn and bmn wherein the numbers m, n can take on values of n, m= 1, 2, 3, 4, 5, 6, etc. Figure 2 also shows the calculation of the spatial distribution of the electromagnetic field of modes b31 and b42. The highest quality factor that is deduced from the peaks of the transmittance spectrum is 1000, due to the limited resolution of the spectrometer. It is obvious that by using a spectrometer with a higher resolution peaks or resonances with a higher quality factor would be observed. In particular, the calculations made show that some of them can manage to reach a quality factor in the region of 1xE9 and to confine the electromagnetic field into a very small volume, in the region of 1 cubic micra. A theoretical calculation of the optical transmission in a sphere of silicon oxide is also shown (in green) of the same size where it can be observed that there are no resonances at those frequencies.

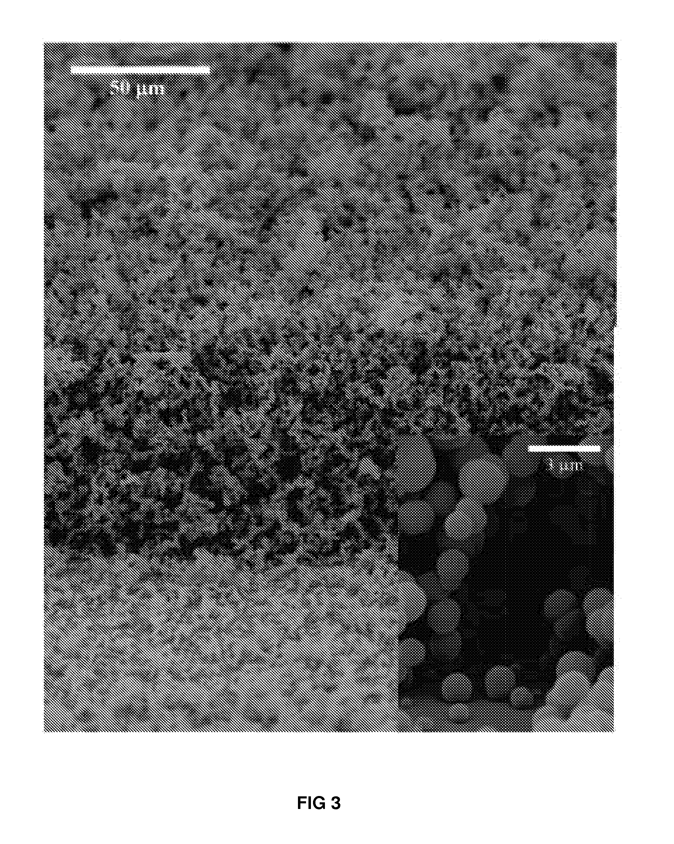

As shown in the examples the microspheres can appear isolated, in the form of clusters or knots of a few units, and in the form of conglomerations or stacks of many units forming a photonic sponge (Figure 3). Likewise, it is also possible to easily separate the microspheres of a conglomeration or a cluster by mechanical methods. The separation method can be carried out through gentle scraping or through very fine grinding or using ultrasonic methods.

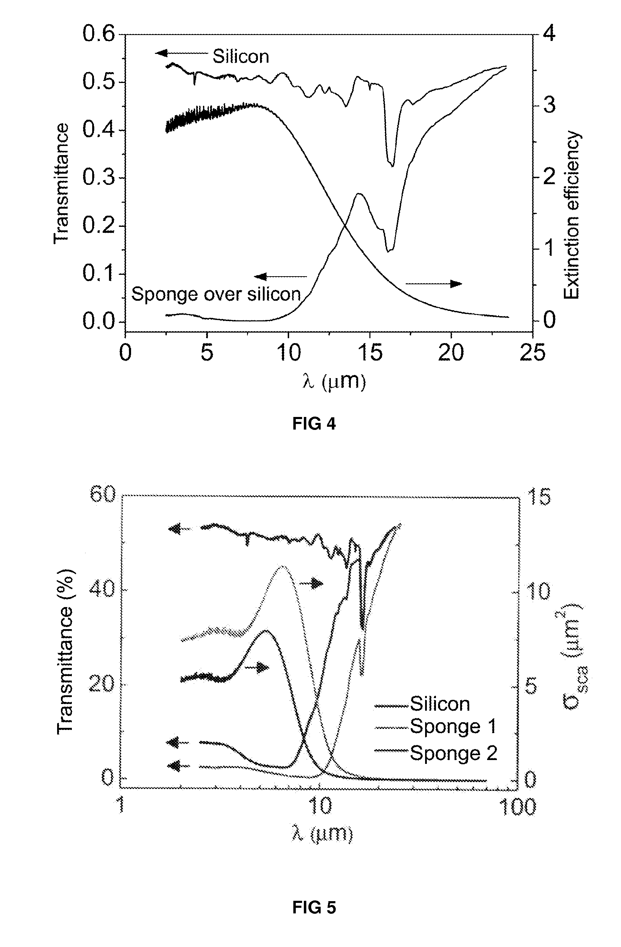

In this sense, a photonic sponge was obtained formed by conglomerations or random distributions of units of microspheres. These sponges can trap and locate light in very small spaces (in the region of the size of the sphere) in a range of wavelengths in which silicon is transparent, specifically between 1 and 15 micras. This localisation of light is explained in terms of Mie resonances and notably favours the occurrence of non linear optical phenomena such as Anderson photon localisation wherein the mean free path of the photon is comparable to the distance between the particles. Figure 3 shows an electronic microscope image at a low magnification of a photonic sponge with a thickness of about 60 micras. The inset corresponds to a part of the sponge at a higher magnification. Figure 4 shows the optical transmittance spectrum of a sponge with a thickness of 13 micras, grown on a wafer of monocrystalline silicon and the transmission spectrum of the same wafer without the sponge in order to be able to compare them. Aside from the absorption peak around 16 micras, which is due to the photons of the grid, it can be clearly observed how the silicon sponge gives rise to a border in the transmission spectrum. The mean point of this border can be situated at 15 micras. The reason for this is that for wavelengths below 15 micras the type of scattering is Mie, in other words, light localisation occurs, whereas for wavelengths above 15 micras the type of scattering is Rayleigh, which is typical when the particle size is lower than the wavelength of the light.

Statistical measurements of the size of the sphere in the measured sponge offer a Gaussian distribution with an average diameter of 1.8 micras and a standard deviation of 0.5 micras. Figure 4 shows a calculation of the effective cross section of Mie scattering of this distribution of spheres. The result is a complementary curve to the sponge's transmission spectrum. The red band explains the transition from Rayleigh scattering to Mie scattering.

Sponges with a mean sphere size different to the previous one give rise to a border in the transmission spectrum situated in a different position to 15 micras. Likewise, the change in the standard deviation of the distribution gives rise to a more or less pronounced border according to whether the standard deviation is lower or higher, respectively. Figure 5 shows the transmittance spectrums of the sponge of figure 4 (blue curve) and of the silicon wafer used as reference, together with another sponge with a thickness of 9 micras, grown on a wafer of monocrystalline silicon. In this case the statistical distribution gives an average size of 1.5 micras and a standard deviation of 0.5 micras. Figure 5 also shows the calculation of the effective cross section of Mie scattering of this distribution of spheres. The result is a complementary curve to the sponge's transmission spectrum. One can observe that when the size of the spheres and the thickness of the layer is reduced the transmission border moves to lower wavelengths.

The localisation of light that is achieved with the microspheres and photonic sponges of the invention in turn favours the occurrence of non linear optical phenomena such as the optical absorption of two or more photons and the laser emission of luminescent ions adsorbed in the silicon cavities. The most immediate applications would be numerous in the field of non linear optics such as lasers, detectors, sensors, etc.

Micrometer-sized silicon spheres would allow important concepts of electronic and photon technology to be integrated in one single device. One future application would be the development of p-n junctions in one single microcavity. This would allow integration in a single device of the microcavity concept with that of the photodiode.

Thus, one aspect of the invention consists of a microsphere, hereinafter microsphere of the invention, made of silicon with a diameter between 0.1 and 50 micras, preferably between 0.5 and 5 micras, with controlled porosity and capable of functioning as an optical type microcavity with Mie resonance modes for wavelengths in the range between 1 and 15 micras, in which the silicon is transparent.

A preferred aspect of the invention consists of the microsphere of the invention wherein the silicon presents a crystalline state of a different nature, for example, amorphous, amorphous hydrogenated, polycrystalline, or monocrystalline state; and moreover, with the microspheres being able to be of solid or porous type.

Another preferred aspect of the invention consists of the microsphere of the invention wherein the material of the particle is a silicon and germanium alloy, in principle in any stechiometric ratio of same.

A preferred embodiment of the invention consists of the microsphere, whether in isolated form or cluster form, made of silicon, and more preferably of solid amorphous silicon.

Another preferred embodiment of the invention consists of the microsphere, whether in isolated form or cluster form, of a silicon and germanium alloy, whether in crystalline or amorphous state.

Another aspect of the invention consists of a grouping, cluster or knot formed by more than one microsphere of the invention, of identical or different size and characteristics.

Another aspect of the invention consists of a photonic sponge, hereinafter photonic sponge of the invention, formed by conglomerations or random distributions of many units of microspheres of the invention, whether of a single or various materials, in a stacking, of the coating or layer type over plane or curved or any type of surfaces. These sponges can localise the light in very small spaces, in a range of wavelengths in which silicon is transparent, specifically between 1 and 15 micras.

Another preferred embodiment of the invention consists of a photonic sponge in which the microspheres are of silicon and/or silicon/germanium alloy, and in which the crystalline state of the mixture may be any of the following: amorphous, amorphous hydrogenated, polycrystalline, monocrystalline, and the microspheres being of the solid or porous type.

Another aspect of the invention consists of the method for producing the microspheres of the invention, hereinafter the method of the invention, which comprises the following stages (see Figure 6):
i) Stage of selection and arrangement of the material, volume and shape of the reaction vial or container (2), as well as of the material, shape and location of the substrate (5) inside it for assembly for chemical vapour deposition,
ii) Stage of decomposition by heating of the precursor compound(s) of silicon, preferably silane and/or disilane, in the form of a gas that is introduced in the reaction vial where it is subjected to suitable decomposition pressure, temperature and time conditions,
iii) Stage of synthesis of the microsphere of the invention based on the chemical vapour deposition that is diffused in the gas, forming nuclei of the material, preferably silicon, within the midst of the gas,
iv) Precipitation or depositing of the microspheres in the form of rain and their depositing on the substrate placed inside the container or on its walls (see examples),
v) Formation of the photonic sponges,
vi) Extraction of the surplus gases from the container or vial (2) through an assembly for chemical vapour deposition,
vii) Opening of the container or vial (b) and extraction of the substrate (d) and of the microspheres and photonic sponges stuck to the container and the substrate for their subsequent purification.

The synthesis by chemical vapour deposition that has been used in this invention is normally used in the technology for the epitaxial growth of various materials, among them silicon (Jasinski, J.M. & Gates, S.M. Silicon Chemical Vapour Deposition One Step at a Time: Fundamental Studies of Silicon Hydride Chemistry. Acc. Chem. Res. 24, 9-15 (1991). An expert in the art and with the information described in this invention can handle and vary the quantities of the precursor gases, for example of disilane (H6Si2) and silane (H4Si) (see examples); the material, volume and shape of the vial or container, the material and shape of the substrate for growing the silicon spheres; the location of the substrate in the vial or container during the silicon particles growth process; decomposition temperature of the gases and decomposition time of the gases, with a view to achieving one or another type of microsphere or photonic sponge of the invention.

The silicon particles obtained by means of the method of the invention have a spherical shape due to the surface tension forces. The synthesis, nucleation and precipitation of the spherical silicon particles is similar to the synthesis of spherical particles of silicon oxide in a liquid medium when a solgel synthesis method is used with adequate precursors (Stöber, W., Fink, A. & Bohn, E. Controlled Growth of Monodisperse Silica Spheres in the Micron Size Range, J. Colloid and Interface Sci. 26, 62-69 (1968)). The spherical particles when deposited stack against each other forming the photonic sponges (Figure 3). The size of the particles obtained varies between 0.5 micras and 5 micras. However, by modifying the reaction parameters this size can be extended to within the range between 0.1 micras and 50 micras.

Another preferred aspect of the invention consists of the method of the invention wherein the precursor material is a silicon precursor material, preferably, silane and/or disilane, in gas form.

Another preferred aspect of the invention consists of the method of the invention wherein the precursor material is a germanium precursor material, preferably, germane, in gas form.

Another preferred aspect of the invention consists of the method of the invention wherein the precursor material is a mixture of precursor materials of silicon and germanium, preferably, disilane, and germane, in gaseous state.

The adequate proportions of the mixtures of silicon precursors (silane and/or disilane), germanium (germane, H4Ge) and diborane (H6B2) can be prepared by an expert in the art in order to obtain a particular alloy according to the final application. When diborane gas is to be used as a doping agent it must be introduced in a lower quantity than the disilane since it is the one that promotes p-type silicon.

Finally, another aspect of the invention consists of the use of the microspheres and photonic sponges of the invention in the manufacture of photonic devices, for example, solar cells, photodiodes, lasers and sensors.

### DESCRIPTION OF THE DRAWINGS

**Figure 1** shows an electronic microscope image of several microspheres where the dispersion of sizes can be appreciated, and the inset shows an electronic microscope image at a higher magnification of a microsphere of approximately 2 micras in diameter. We would highlight the sphericity and low roughness of the sphere's surface.
**Figure 2** shows the measurements of optical transmittance of a single sphere of 1.88 micras in diameter (red curve) and the calculations of optical transmittance (in black) according to the Mie theory for a sphere of that size. In the figure the assignment of the different resonances to the different modes of the microcavity amn and bmn are also shown, wherein the numbers m, n can take on values of n, m= 1, 2, 3, 4, 5, 6 etc. The lower part of the figure shows the calculation of the spatial distribution of the electromagnetic field of modes b31, and b42.
**Figure 3** shows a low magnification electronic microscope image of a photonic sponge of the invention with a thickness of approximately 60 micras. The inset corresponds to an image of the same sponge at a high magnification.
**Figure 4** shows a transmission curve of a photonic sponge of 13 micras in thickness deposited on a wafer of crystalline silicon, and the transmission curve of the same wafer without the sponge in order for comparison. Apart from the absorption valley around 16 micras which is due to vibrations of Si-Si and Si-H junctions, a drop or border is observed in the transmission spectrum of the sponge that can be placed at approximately 15. This border indicates a scattering type transition from Mie type (for wavelengths less than 15 micras) to Rayleigh type (for wavelengths more than 15 micras). A calculation is also shown of the effective cross section of scattering due to a Gaussian distribution of spheres with an average diameter of 1.8 micras and a standard deviation of 0.5 micras, which corresponds to the measured sponge.
**Figure 5** shows the transmittance spectrums of two sponges with different parameters. The red curve corresponds to a sponge with 13 micras in thickness with an average sphere size of 1.8 micras and a standard deviation of 0.5 micras. This curve is the same one as that of Figure 4. The blue curve corresponds to a sponge with 9 micras in thickness with an average sphere size of 1.5 micras and a standard deviation of 0.4 micras. Figure 5 also shows the calculation of the effective cross section of Mie scattering of this distribution of spheres. The result is a complementary curve to the sponge's transmission spectrum. It can be observed how when the size of the spheres and the thickness of the layer is reduced the transmission border moves to lower wavelengths.
**Figure 6** shows two configurations **A** and **B** corresponding to different ways of placing the substrate on which the microspheres are deposited. The numbers correspond to a: **1**) Tubular oven; **2**) Quartz vial or container; **3**) Vial opening and lock; **4**) Gas input and output. It can be opened and closed using the lock 3; **5**) Substrate on which the microspheres are deposited.

### EXAMPLES OF EMBODIMENTS OF THE INVENTION

Below particular modes of embodiment of the invention are shown for the manufacture of silicon microspheres and photonic sponges based thereon. The size of the vial and oven used in all of the examples are as follows: Quartz vial: Diameter: 2 cm, Length: 15 cm, Volume: 47 ml; and a Tubular Oven: Length: 20 cm, Diameter: 3.5 cm.

### Example 1.- Synthesis of a photonic sponge of amorphous silicon of 13 micras in thickness formed by particles with sizes between 0.5 micras and 5 micras and enlargeable to sizes between 0.1 and 50 micras

In this example, configuration A of Figure 5 is used. The process can be summarised in the following steps:
- Step 1: Lock 3 is removed from the vial and the substrate on which the microspheres are deposited is introduced. The substrate is made of quartz so that it can resist high temperatures.
- Step 2: The lock 3 is placed back on the vial in such a way that the mouth 4 remains open. The vial is connected through the mouth 4 to a CVD line (Chemical Vapour Deposition), which can make a vacuum and introduce gases into the vial.
- Step 3: A vacuum is made in the vial up to a pressure of 1 xE-4 torr.
- Step 4: Disilane is introduced into the vial using a liquid nitrogen trap. The amount of introduced disilane is 20 mg.
- Step 5: The lock 3 is closed and the vial is removed from the CVD line. Next, the vial is introduced in the oven at 450ºC, as shown in Figure 5, configuration A. In this way the substrate is left in the medium point of the oven, where the temperature achieved is more stable and is the one marked by the oven temperature controller.
- Step 6: The vial is kept in the oven for one hour at a temperature of 450ºC.
- Step 7: The vial is removed from the oven and connected through mouth 4 to the CVD line once again. The mouth 4 is opened in order to eliminate the remaining gases produced by the reaction such as surplus disilane and hydrogen. These gases are explosive in contact with the air; therefore, they are trapped and deactivated in part of the CVD line.
- Step 8: The lock 3 is removed from the vial and the substrate containing the microspheres is extracted.

The method of this example gives rise to a sample with the following characteristics:

A layer of silicon of approximately 1 micra has formed on the substrate on both the side that is touching the walls of the vial (let's call it wall side) as well as on the opposite side (let's call it free side). On top of this layer of silicon one finds: on the wall side isolated microspheres such as the ones appearing in Figure 1 (a) and (b), and on the free side a photonic sponge like the one appearing in Figure 3. This sponge is fragile and can be easily separated from the substrate using a scalpel for example. If this method is carried out, isolated microspheres remain on the substrate such as those appearing in Figure 1 (a). On both sides the microspheres are grey in colour, with diameters between 0.5 and 5 micras and are of amorphous silicon. However, by modifying the parameters of the reaction this size can be extended to the range between 0.1 micras and 50 micras.

From these sponges the spherical particles can be obtained by means of very fine grinding, or ultrasounds that separate said particles.

### Example 2.- Synthesis of microspheres of amorphous and porous silicon with sizes between 0.5 micras and 2 micras.

This example is the same as example 1 except in step 6, which now is:
- Step 6: The vial is kept in the oven during 5 minutes at the temperature of 450ºC.

The method of this example gives rise to a sample with the following characteristics:

A layer of silicon of less than 1 micra has formed on the substrate on both the side touching the walls of the vial (let's call it wall side) and on the opposite side (let's call it free side). On top of this layer of silicon isolated microspheres appear and sometimes on the free side in small clusters.

These microspheres are red in colour and have a diameter between 0.5 micras and 2 micras. They are made of amorphous silicon and are porous.

### Example 3.- Synthesis of a photonic sponge of polycrystalline silicon of 13 micras in thickness formed by particles with sizes between 0.5 micras and 5 micras and enlargeable to sizes between 0.1 and 50 micras.

This example is the same as example 1 except in step 6, which is now:
Step 6: The vial is kept in the oven during 1 hour at the temperature of 800ºC.

The resulting sample is similar to that of example 1 except that the silicon is now polycrystalline instead of amorphous.

From these sponges the spherical particles can be obtained by means of very fine grinding, or ultrasounds that make said particles separate.

### Example 4 Synthesis of microspheres of amorphous and porous silicon with sizes between 0.5 micras and 5 micras and enlargeable to sizes between 0.1 and 50 micras

In this example configuration B of Figure 5 is used. In this case the substrate is outside the area where the vial is heated. The same steps are followed as in example 1.

The method of this example gives rise to a sample with the following characteristics:

The layer of silicon that had formed on the substrate in the previous examples is not formed now. The side of the substrate that faces the oven shows isolated microspheres, in clusters and also in sponge shape, with a sphere diameter between 0.5 and 5 micras. The silicon is amorphous. However, by modifying the reaction parameters this size can be extended to the range between 0.1 micras and 50 micras.

From these sponges the spherical particles can be obtained by means of a very fine grinding, or ultrasounds that make said particles separate. The opposite side of the substrate does not show any microspheres.

With a view to carrying out optical measurements and so that the layer of silicon on which the microspheres are found in examples 1, 2 and 3 does not influence them, these may be separated from the original substrate and be deposited on another substrate of glass or quartz for example. This can be done in various ways, one of them is by rubbing the two substrates together.

## Claims

1. Microsphere **characterised in that** it is made of silicon with a diameter between 0.1 and 50 micras, preferably between 0.5 and 5 micras, with controlled porosity and capable of functioning as an optical microcavity with Mie resonance modes for wavelengths in the range between 1 and 15 micras, in which silicon is transparent.

2. Microsphere according to claim 1 **characterised in that** the silicon presents a crystalline state of a different nature, for example, amorphous state, amorphous hydrogenated, polycrystalline, monocrystalline.

3. Microsphere according to claim 1 **characterised in that** the microsphere is of solid or porous type.

4. Microsphere according to claim 1 **characterised in that** the material of the microsphere is a silicon and germanium alloy, in any stechiometric ration thereof.

5. Microsphere according to claim 1 **characterised in that** it is presented in isolated form or in cluster form, is of silicon, and more preferably, is of solid amorphous silicon.

6. Microsphere according to claim 1 **characterised in that** it is presented in isolated form or in cluster form, is an alloy of silicon and germanium, whether in crystalline or amorphous state.

7. Microsphere according to claim 1 **characterised in that** it is presented in the form of a grouping, cluster or knot formed by more than one microsphere, of identical or different size and characteristics.

8. Photonic sponge **characterised in that** it is formed by conglomerations or random distributions of many units of the microsphere according to claims 1 to 7, whether of one single or various materials, in a stacking, of the coating or layer type on plane or curved or any other type of surfaces.

9. Photonic sponge according to claim 8 **characterised in that** the microspheres are of silicon and/or alloys of silicon/germanium, and **in that** the crystalline state of the mixture may be any of the following: amorphous, amorphous hydrogenated, polycrystalline and monocrystalline.

10. Photonic sponge according to claims 8 and 9 **characterised in that** the microspheres are of solid and/or porous type.

11. Method for production of the microspheres and photonic sponge according to claims 1 to 10 **characterised in that** it comprises the following stages (see Figure 6):
i) Stage of selection and arrangement of the material, volume and shape of the reaction vial or container (2), as well as the material, shape and location of the substrate (5) inside it for assembly for chemical vapour deposition,
ii) Stage of decomposition by heating of the precursor compound(s) of silicon, preferably silane and/or disilane, in the form of a gas introduced in the reactor/vial where it is subjected to suitable decomposition pressure, temperature and time conditions,
iii) Stage of synthesis of the microsphere of the invention based on the chemical vapour deposition that is diffused in the gas, forming nuclei of material, preferably silicon, in the midst of the gas,
iv) Precipitation or depositing of the microspheres in the form of rain and their depositing on the substrate introduced in the container or on its walls (see examples),
v) Formation of the photonic sponges,
vi) Extraction of the surplus gases from the container or vial (2) using an assembly for chemical vapour deposition,
vii) Opening of the container or vial (b) and removal of the substrate (d) and the microspheres and photonic sponges stuck to the container and to the substrate for their subsequent purification.

12. Method according to claim 11 **characterised in that** the precursor material of i) is a precursor material of germanium, preferably germane, in gaseous state.

13. Method according to claim 11 **characterised in that** the precursor material of i) is a mixture of the precursor materials of silicon and germanium, preferably disilane, and germane, in gaseous state.

14. Method according to claim 11 **characterised in that** diborane is included as a doping agent of the reaction together with the disilane, in gaseous state.

15. Use of the microspheres and photonic sponges of claims 1 to 10 in the manufacture of photonic devices, for example, solar cells, photodiodes, lasers and sensors.
